Europäisches Patentamt

European Patent Office

Office européen des brevets

(11) Publication number: 0 266 937
A1

## (12) EUROPEAN PATENT APPLICATION

(21) Application number: 87309270.4

(22) Date of filing: 20.10.87

(51) Int. Cl.4: H01L 21/82

(30) Priority: 27.10.86 US 923531

(43) Date of publication of application:
11.05.88 Bulletin 88/19

(84) Designated Contracting States:
BE DE ES FR GB IT NL

(71) Applicant: AMERICAN TELEPHONE AND
TELEGRAPH COMPANY
550 Madison Avenue
New York, NY 10022(US)

(72) Inventor: Kye, Hwan Oh
820 Hamilton Mall
Allentown Pennsylvania 18101(US)
Inventor: Scott, Francis Shive
1420 Quarry Drive
Bethlehem Pennsylvania 18017(US)

(74) Representative: Watts, Christopher Malcolm
Kelway, Dr. et al
Western Electric Company Limited 5,
Mornington Road
Woodford Green Essex, IG8 0TU(GB)

(54) Complementary semiconductor device production.

(57) An integrated circuit having complementary
(e.g., CMOS) devices is produced by a technique
that allows both n-type and p-type source/drain re-
gions to be formed with a single lithography step.
For example, after defining transistor gate regions
(12,14), an ion implant forms the source/drain re-
gions of a first conductivity type (e.g., n-type) at all
the transistors sites. A lithography step forms a
masking layer (20) (e.g., photoresist) at the sites
where that conductivity type is to be retained, and
an etching step removes the implanted ions from the
other transistor sites. An ion implant of the second
conductivity type (e.g., p-type) is subsequently per-
formed. The masking layer may be removed, and a
dopant drive-in step performed, to complete the
source/drain region formation.

# COMPLEMENTARY SEMICONDUCTOR DEVICE PRODUCTION

## Background of the Invention

### 1. Field of the Invention

The present invention concerns a technique for producing a semiconductor device having both n-type and p-type source/drain regions. An example is the case of CMOS integrated circuits.

### 2. Description of the Prior Art

The production of semiconductor devices usually requires that doped regions of more than one conductivity type be formed in a semiconductor body. One commercially significant example is the case of CMOS integrated circuits, wherein both n-type and p-type source/drain regions are utilized on the same integrated circuit chip. In a typical CMOS process, the gate and field oxide regions are initially formed on a silicon substrate. A photoresist layer is then patterned to allow ions of the first conductivity type (e.g., p-type) to be implanted into the substrate only in the regions where the source/drain regions of that type are desired. That photoresist layer is then removed, and the process repeated for the opposite conductivity type (e.g., n-type) regions. However, that technique requires two lithographic operations, which is costly and prone to introducing errors into the process that reduce the yield of usable integrated circuit chips.

Therefore, techniques that require only one lithographic operation to define source/drain regions of both conductivity types have been developed. These "one mask" operations frequently make use of the different oxidation rates between lightly and heavily doped silicon. For example, in one process, the lithographic step defines openings in the photoresist layer where the n-type source/drain regions are desired. Arsenic ions (n-type) are then implanted into these regions the resist removed and the silicon wafer placed in an oxidation furnace. The silicon in the heavily doped n-type regions oxidizes faster than in the other source/drain regions, thereby producing a thicker oxide layer over the n-type regions. This is followed by a p-type ion implant, during which the thick oxide on the n-regions shield them from the p-type ions, whereas the thinner oxide on the other regions allows the p-type ions to pass into the substrate. A dopant drive-in heating step completes the formation of the n- and p-type source/drain regions.

One limitation on the differential oxidation technique is that the oxide growth conditions typically produce high temperatures that cause the previously implanted dopant to diffuse into the substrate. This makes it difficult to achieve very shallow junctions (e.g., less than 0.1 micrometer deep). Furthermore, the oxidation conditions have to be carefully controlled, to ensure that the oxide is sufficiently thick on one region to block the ions, and simultaneously sufficiently thin on the other region to allow the ions to pass into the substrate. In still another one-mask technique, a p-type dopant (e.g., boron) is implanted in all the source/drain regions, and a photoresist mask used to cover the locations where the n-channel transistors are to be formed. Then a relatively heavier dose of n-type dopant (e.g. arsenic) is implanted, thereby overcompensating the p dopant and forming n-type source/drains. However, that technique frequently requires such a heavy n-type implant dose that the resulting semiconductor crystal lattice damage is difficult to anneal out. It is desirable for these and other reasons to have an alternative technique for forming both p-type and n-type source/drain regions using a single lithography step.

## Summary of the Invention

We have invented a technique of making a semiconductor device having both n and p doped source/drain regions. A first dopant of a first conductivity type is introduced into a surface portion of a semiconductor body, typically by ion implantation. A masking layer is formed to overlie a first region of the semiconductor body, and an etching step removes the surface portion of a second region of the semiconductor body, thereby substantially removing the introduced first dopant from that region. A second dopant of a second conductivity type is introduced into the second region, being blocked by the masking layer from being introduced into the first region. A dopant drive-in step then extends the depth of the dopants in the semiconductor body.

## Brief Description of the Drawing

Fig. 1 illustrates implanting a first dopant into a semiconductor body.

Fig. 2 illustrates masking selected regions of the semiconductor body.

Fig. 3 illustrates etching the surface portions of unmasked regions of the semiconductor body, thereby removing the first dopant therefrom.

Fig. 4 illustrates implanting a second dopant into the unmasked regions of the semiconductor body.

Fig. 5 illustrates a dopant drive-in step for extending the depth of the doped regions in the semiconductor body.

Fig. 6 illustrates a lightly doped drain ($L_{DD}$) structure using the present technique.

Detailed Description

The following detailed description relates to a technique for forming n and p doped source/drain regions in a semiconductor body. The present technique is illustratively described for forming source/drain regions in a silicon substrate in the production of a CMOS integrated circuit. However, other semiconductor types, for example group III-V semiconductors, may be utilized with the appropriate choice of dopants and etchants for the production of complementary integrated circuits and other devices.

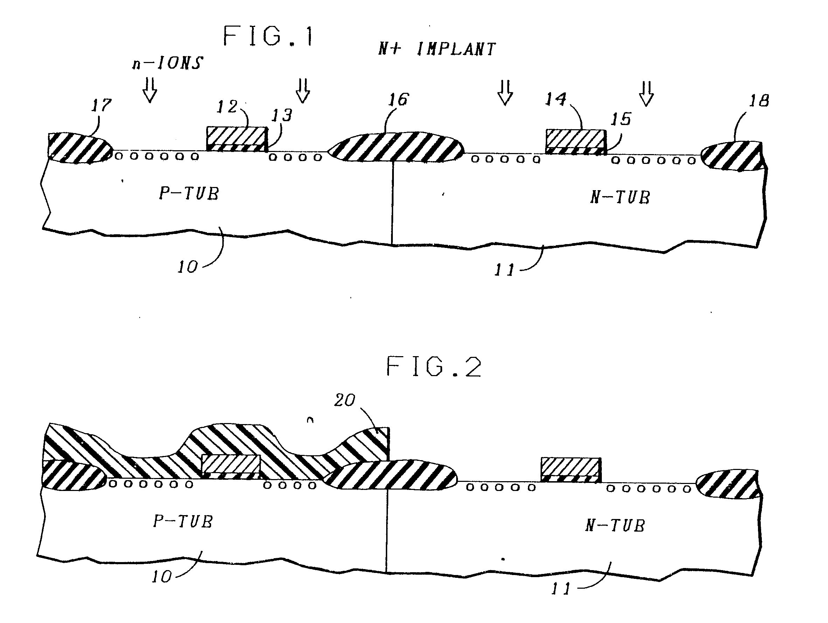

Referring to Figure 1, a semiconductor body has formed therein a p-doped region (10) and a n-doped region (11). One or both of these regions may be "tubs" formed in a semiconductor wafer or epitaxial layer thereon, and typically have relatively light doping levels as compared to the source/drain regions to be subsequently formed by the present technique. Field oxide regions (16, 17, and 18) may be formed by known techniques to isolate the subsequently formed transistors. The gate regions for an n-channel transistor, comprising gate oxide 13 and gate electrode 12, and for a p-channel transistor, comprising gate oxide 15 and gate electrode 14, are formed by known techniques. If desired, a sidewall spacer (not shown) may optionally be formed on the sidewalls of the gate oxide and electrode to assist in the formation of a "lightly doped drain" device, according to techniques known in the art. After forming the gates, ions of a first conductivity type, e.g., n-type, are implanted as indicated, typically to a depth of about 21.5 nanometers (215 angstroms) into the substrate, as measured from the surface of the substrate to the peak concentration of the implant. With typical ion beam energies used for the implant operation in current CMOS technology, the depth of the implant peak is less than 50 nanometers (500) angstroms.

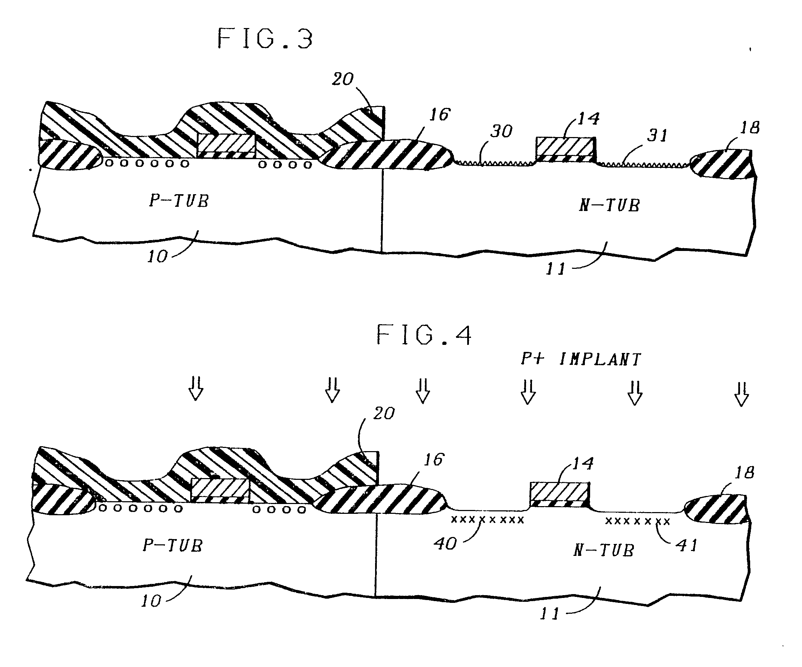

Referring to Figure 2, a photoresist layer is applied, irradiated with lithographic patterning radiation, and developed to produce photoresist masking region 20 that remains on the p-tub portion of the substrate. Referring to Figure 3, an etching operation removes a thin surface layer of unprotected portions of the semiconductor substrate in the n-tub region. Note that the p-tub region of the semiconductor substrate is protected by the photoresist masking layer (20). Portions of the n-tub region are protected from the etching by the field oxide regions 16 and 18, and the gate electrode 14. However, the source/drain regions of the substrate are left unprotected, allowing the etching to remove a thin surface portion of the semiconductor substrate in regions 30 and 31. When etching silicon, a suitable etchant is $Cl_2$ gas at a pressure of 10 micrometers of $H_g$ (1.3 pascal) in a reactive ion etching machine. A suitable reactive ion etching apparatus is described in U.S. Patent 4,298,443 co-assigned with the present invention. For example, etching at bias of 225 volts for 3 minutes removes a layer of silicon 50 nanometers (500 angstroms) thick.

The thickness of the surface portion removed is typically chosen so as to remove at least the major portion of the dopant species implanted in the operation of Figure 1. This may be accomplished by etching at least to the projected ion range (where the ion concentration falls to less than 0.3 of the peak value). With current and future envisioned processes, this implies etching into the semiconductor at least 10 nanometers (100 angstroms). However, it is desirable to minimize overetching, in order to minimize the step height difference between the etched region and the gate electrode. Hence, in the present technique, the etching is typically accomplished to remove less than 50 nanometers (500 angstroms) of the semiconductor. Future implant depths may be shallower than those presently used, allowing for even less etching depth than that typically used at present.

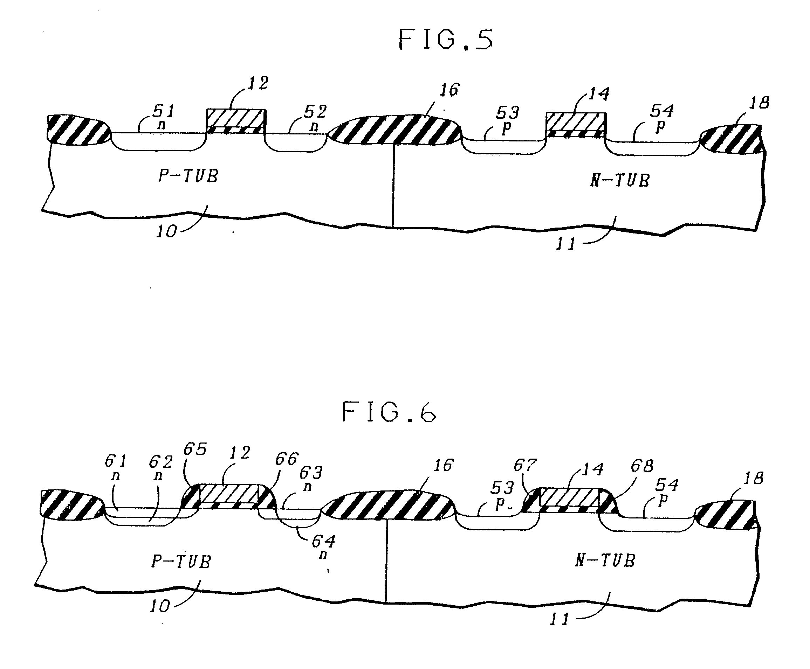

Referring to Figure 4, ions of a second conductivity type, e.g., p type, are implanted into the structure thus formed. The masking layer (photoresist layer 20) prevents the p ions from reaching the semiconductor substrate in the p-tub region. The field oxide regions (16, 18) and the gate electrode (14) prevent the p ions from reaching the silicon substrate in those portions of the n-tub region. Hence, the ions are implanted in the regions 40, 41 in the n-tub from which the surface layer (and the n-type implant) had been removed previously. Referring to Figure 5, the photoresist layer may then be removed and the substrate heated to an elevated temperature to perform a dopant drive-in step, resulting in source/drain regions 51-54 of the desired depth in the substrate. In present integrated circuits, the depth of these regions, referred to as the "junction depth", is typically less than 1 micrometer, and usually about 0.5 micrometers in current designs. It is anticipated that junction depths will decrease further, reaching perhaps 0.1 micrometers or even less in future designs with CMOS technology.

The present technique also lends itself to forming source/drain regions with a lightly doped drain (LDD) transistor structure. In a typical sequence of operations, a relatively light dose of phosphorus (n-type dopant) is implanted as shown in FIG. 1, followed by the formation of the sidewall regions. The formation of the sidewall regions (65...68 in FIG.6) may be by any of a variety of techniques known in the art. In one typical technique, a silicon dioxide layer is conformably deposited over the substrate, and anisotropically etched, leaving the sidewall regions. Then, a relatively heavier dose of arsenic (n-type dopant) is implanted, and the masking region (20) formed. The etching of the semiconductor substrate in the unmasked region then removes the arsenic dopant from the source/drain region of the p-channel device. Boron (p-type dopant) is then implanted, and the masking layer removed. A drive-in heating step then produces the structure of FIG. 6, wherein the phosphorus is located in regions 61 and 63, and the arsenic extends into regions 62 and 64, thereby forming the source/drain regions of the n-channel transistor. The boron in regions 53 and 54 forms the source/drain regions of the p-channel transistor, as before. Since the boron is implanted at a heavier dose than the phosphorus, the boron overcompensates the phosphorus in the region under the sidewall spacers 67 and 68, so that the p-channel may form. If desired, the sidewall spacers may be etched away from the p-channel devices while the masking layer is still in place, thereby allowing the complete removal of the phosphorus dopant from the p-channel source/drain regions.

While the use of a photoresist, or more generally a resist sensitive to any form of lithographic radiation, has been illustrated as the masking layer herein, other masking layer types are possible in addition to, or in lieu of, a resist. For example, a resist may be used to pattern an underlying inorganic layer (e.g., an oxide), after which the resist may be removed. The underlying layer may then serve to mask the first semiconductor region during the etching and subsequent implant operations. In another example, the resist may be retained during the etching operation, and then removed, leaving an underlying (inorganic) layer to prevent the second dopant from being introduced into the second semiconductor region. This can be useful for optimizing the properties of the masking layer for these operations, and to allow, for example, high temperature operation between the etching and second implant steps that would degrade a photoresist. Note that only a single lithography step is still required, since an upper resist layer may be used to define an underlying layer. The resist itself may comprise two or more layers, as in the case of bilevel and trilevel resists known in the art. As used herein, any and all such layers are included in the term "masking layer".

## Claims

1. A method of making a semiconductor device wherein at least one n-channel field effect transistor and at least one p-channel field effect transistor are formed in a semiconductor body,
CHARACTERIZED by steps comprising:
introducing a first dopant of a first conductivity type into a surface portion of a semiconductor body;
selectively forming a masking layer (20) so as to overlie a first region of said semiconductor body;
removing a surface portion of a second region of said semiconductor body, thereby substantially reducing the amount of the introduced first dopant in said second region, wherein said masking layer prevents the removal of the surface portion of said first region;
introducing a second dopant of a second conductivity type opposite said first type into said second region, wherein a masking layer prevents said second dopant from being introduced into said first region; and
heating the first and second regions to an elevated temperature, thereby diffusing said first and second dopants deeper into said semiconductor body.

2. The method of claim 1 further comprising the step of removing said masking layer prior to said step of heating.

3. The method of claim 1 wherein said diffusing produces doped regions having junction depths of less than 0.5 micrometers.

4. The method of claim 1 wherein said semiconductor is silicon.

5. The method of claim 4 wherein said first conductivity type is n-type, and said second conductivity type is p-type.

6. The method of claim 1 wherein said introducing is accomplished by ion implantation.

7. The method of claim 1 wherein said removing is accomplished by etching.

8. The method of claim 7 wherein said etching is reactive ion etching.

9. The method of claim 7 wherein said etching is liquid chemical etching.

10. The method of claim 1 wherein the surface portion that is removed is at least 10 nanometers thick.

11. The method of claim 1 wherein the surface portion that is removed is less than 50 nanometers thick.

12. The method of claim 1 wherein said introducing a first dopant is accomplished by implanting ions to a depth less than 50 nanometers into said semiconductor body.

13. The method of claim 1 wherein the bulk of said first region is p-type, said first conductivity type is n-type, the bulk of said second region is n-type, and said second conductivity type is p-type.

14. A semiconductor body having a broad surface area, wherein at least one first source/drain region and at least one second source/drain region are formed in said body by the introduction of first and second dopant species into the surface portions of the first and second regions, respectively, CHARACTERIZED in that

the surface of said second source/drain region is recessed in said semiconductor body as compared to the surface of said first source/drain region, and wherein the depth of the recess is at least approximately the depth of said first dopant species as introduced into said first region.

15. The semiconductor body of claim 14 wherein said body comprises an integrated circuit.

16. The semiconductor body of claim 14 wherein said introduction is accomplished by ion implantation.

17. The semiconductor body of claim 14 wherein said first dopant species is an n-type dopant, and said second dopant species is a p-type dopant.

18. The semiconductor body of claim 14 wherein the depth of said recess is at least 10 nanometers.

19. The semiconductor body of claim 14 wherein the depth of said recess is less than 50 nanometers.

FIG.1

n-IONS

N+ IMPLANT

17    12  13    16    14  15    18

P-TUB    N-TUB

10    11

FIG.2

20

P-TUB    N-TUB

10    11

0 266 937

# FIG.3

P-TUB    N-TUB

20    16    30    14    31    18

10    11

# FIG.4

P+ IMPLANT

20    16    14    18

P-TUB    40    N-TUB    41

10    11

0 266 937

## FIG.5

## FIG.6

0 266 937

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EXTENDED ABSTRACTS, vol. 83, no. 2, 9th-14th October 1983, pages 506-507, abstract no. 319, Washington, DC, US; I. BEINGLASS et al.: "A new method for fabricating zener diodes compatible with CMOS technology" * Whole document * | 1,4,6,7,10,14,15,16,18 | H 01 L 21/82 |
| Y | --- | 5,13,17 | |
| Y | EP-A-0 169 600 (MONOLITHIC MEMORIES INC.) * Claims 1-4; figures 17-24 * | 5,13,17 | |

**TECHNICAL FIELDS SEARCHED (Int. Cl.4)**

H 01 L

The present search report has been drawn up for all claims

| Place of search | Date of completion of the search | Examiner |
|---|---|---|
| THE HAGUE | 05-02-1988 | GELEBART Y.C.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)